(19) Europäisches Patentamt
European Patent Office
Office européen des brevets

(11) Publication number: **0 281 278 B1**

(12) **EUROPEAN PATENT SPECIFICATION**

(45) Date of publication of patent specification :
11.09.91 Bulletin 91/37

(51) Int. Cl.⁵ : **H05B 3/26, C03C 17/36, C23C 4/02**

(21) Application number : 88301360.9

(22) Date of filing : 18.02.88

(54) Electroconductive coatings.

(30) Priority : 03.03.87 GB 8704967

(43) Date of publication of application :
07.09.88 Bulletin 88/36

(45) Publication of the grant of the patent :
11.09.91 Bulletin 91/37

(84) Designated Contracting States :
AT BE CH DE ES FR IT LI LU NL SE

(56) References cited :
EP-A- 268 503
DE-A- 2 227 238
DE-A- 3 632 348
DE-B- 1 088 198
GB-A- 2 111 864

(56) References cited :
GB-B- 2 041 985
US-A- 2 954 454
PATENT ABSTRACTS OF JAPAN, vol. 6, no.
165 (C-121)[1043], 28th August 1982; & JP-A-57
82 485 (MATSUSHITA DENKI SANGYO K.K.)
22-05-1982

(73) Proprietor : PILKINGTON PLC
Prescot Road
St. Helens, Merseyside WA10 3TT (GB)

(72) Inventor : Evason, John
15 Glencoyne Drive
Southport Merseyside PR9 9TS (GB)

(74) Representative : Pendlebury, Anthony et al
PAGE, WHITE & FARRER 54 Doughty Street
London WC1N 2LS (GB)

## Description

The invention relates to glass carrying an electroconductive coating and, in particular, to a method of applying bus bars to the glass to establish electrical contact with the coating and to coated glass provided with bus bars in accordance with the invention.

It is known to apply a thin translucent electroconducting layer of metal or doped metal oxide to glass for architectural use or use in vehicle windows. The electroconducting layer generally has a high infra red reflection (low emissivity) so that the coated glass may be useful for either its electroconductivity and/or its optical properties. When an electroconductive metal layer is used, a layer of metal oxide, for example tin oxide or zinc oxide, is generally applied over the metal layer to protect the metal layer. The layer of metal oxide may also serve as an anti-reflection layer. One form of such coated glass, in which a silver layer is sandwiched between two anti-reflection layers of metal oxide on the glass surface, is commercially available as KAPPAFLOAT glass (KAPPAFLOAT is a trade mark of Pilkington plc, of St. Helens, England).

When the electroconducting properties of the glass are to be utilised, for example when the coating is to serve as a heating film, or as a burglar alarm or as an electromagnetic shield, it is necessary to make electrical contact with the metal layer. This may be done by applying highly conducting bus bars to the coated glass surface.

One known way of applying bus bars to glass is by printing a ceramic silver ink comprising a low melting glass frit, particles of silver and an organic binder onto the glass surface and heating the glass to melt the glass frit and fire the ink onto the glass surface, while the organic binder is burnt off. However, although the method is suitable for applying bus bars to thermally stable doped metal oxide coatings, it is not generally suitable for applying bus bars to coatings including metal layers which are not thermally stable and deteriorate during the heating cycle required to fire the conductive ink on to the coated glass surface.

A possible way of avoiding this problem and providing durable bus bars for heat sensitive metal layers would be to print the conductive ink on to the glass and fire it before applying the conductive metal layer to the glass. German patent specification DAS 2044675 describes a process in which copper alloy bus bars are applied to a glass substrate by flame spraying and a conductive coating, to be used as a heating element, is applied over the bus bars. However, processes in which the bus bar is deposited before the electroconducting coating are inconvenient and expensive to operate, and it is desirable to have a process which enables the bus bars to be applied after coating. The glass can then be coated in large, stock size panes, without any special pretreatment such as that needed to apply the bus bars, and the coated panes cut up to give panes of the required size for subsequent application of the bus bars.

It has been proposed to print bus bars on glass carrying a heat sensitive conductive coating using a uv-curable electroconductive epoxy ink and then curing the ink by exposure to ultra violet light, so avoiding the need to heat the coated glass. However, the resultant bus bars have a number of disadvantages, in particular, they have poor durability, they are difficult to solder to, and, when applied to coatings comprising a protective metal oxide layer over a conductive layer, the contact resistance between the bus bars and the metal layer is not reproducible and may be unacceptably high. This high contact resistance is presumably due to the insulating effect of the metal oxide layer over the metal layer, and U.S. patent 4,459,470 describes a method of reducing such contact resistance by applying a high voltage between such a coating and a bus bar to destroy or short out the insulating layer between the bus bar and the metal layer. However, this is a troublesome procedure and the resultant bus bars, if made with a low temperature curing epoxy ink, still suffer from the disadvantages of poor durability and difficult soldering referred to above.

There is a need for a process of depositing bus bars, suitable for use on heat sensitive coatings, which does not suffer from the disadvantages of using UV-curable electroconductive epoxy inks referred to above.

It has now been found that a durable bus bar with good electrical contact to a heat sensitive electroconductive coating can be applied, in a simple procedure without the need to heat the coated glass, by arc spraying molten metal onto the coated glass.

According to the present invention, there is provided a method of applying a bus bar to an electroconductive coating on a glass substrate comprising a layer of metal oxide over an intermediate layer of silver, comprising the step of arc spraying molten metal in the required configuration onto the surface of the electroconductive coating in a manner which enables the molten metal to penetrate the metal oxide layer and to come into low resistance electrical contact with the intermediate layer of silver without damaging the layer of silver, characterised in that the molten metal is sprayed to form a continuous path on the electroconductive coating and to wrap around onto an edge face of the glass substrate.

It is found that the sprayed molten metal layer makes good electrical contact with the silver layer, even through a thin protective layer of non-conductive metal oxide, without any visible damage or noticeable deterioration in the properties of the coating.

The molten metal may be for example, copper, zinc, tin, a tin-zinc alloy, stainless steel, nickel, brass or a copper nickel alloy, for example Monel metal. However, when good adhesion of the bus bar to the coating is required, it is preferred to use aluminium. If desired, the aluminium may be oversprayed with a metal which is easier to solder to, and/or is less prone to atmospheric oxidation leading to loss of conductivity, for example the metals listed above.

The molten metal is applied by arc spraying. It is not necessary to heat the coated glass and metal can be sprayed onto the coated glass surface at room temperature. The configuration of the bus bars may be controlled using a re-usable stencil over the coated glass surface, or by defining the required configuration between strips of adhesive tape applied to the coated glass surface before the metal spraying operation and subsequently removed.

It has been found that particuarly durable bus bars can be produced by spraying a base layer of aluminium onto the coated glass surface, and overspraying the aluminium with a layer of a metal which is less prone to atmospheric oxidation, for example, the metals listed above.

The method of the present invention is applicable to the application of bus bars to electroconductive coatings by arc spraying molten metal in a required configuration and in a continuous path on to the electroconductive coating and to wrap around onto the face opposite the electroconductive coating also.

According to a further aspect of the invention there is provided a glass pane carrying an electroconductive coating, comprising a layer of metal oxide over a layer of silver and at least one bus bar of arc sprayed metal over said electroconductive layer, the arc sprayed metal having penetrated the metal oxide layer so as to be in low resistance electrical contact with the layer of silver without causing damage to the layer of silver, characterised in that the arc sprayed metal on the electroconductive coating extends in a continuous path onto an edge face of the glass pane.

The invention will be more readily understood from the following description and exemplary examples when read in conjunction with the accompanying drawings, in which :

Figure 1 is a diagrammatic plan view (not to scale) of the pane with strips of tape defining a wide margin around the pane ;

Figure 2 is a diagrammatic plan view (not to scale) of the pane with strips of tape defining parallel rectangular strips for the bus bars ; and,

Figure 3 illustrates a sectional side-view (not to scale) including a pane shown in Figure 1 incorporated in a laminate, and showing the bus bar is formed around the edge face extending to the opposite face of the pane.

The invention is illustrated by the following Examples.

Example 1

A rectangular pane of 4 mm glass coated with a translucent electroconductive coating comprising a layer of silver sandwiched between anti-reflection layers of tin oxide (produced as described in U.K. patent 2,129,831B) was cut to a size of 510 mm × 360 mm. The coating had a sheet resistance of 10 ohms per square (measured using a 4 point probe which penetrates the tin oxide layer). The central portion of the pane was then masked on the coated side using strips of low tack adhesive tape, leaving a 20 mm margin exposed around the periphery of the pane.

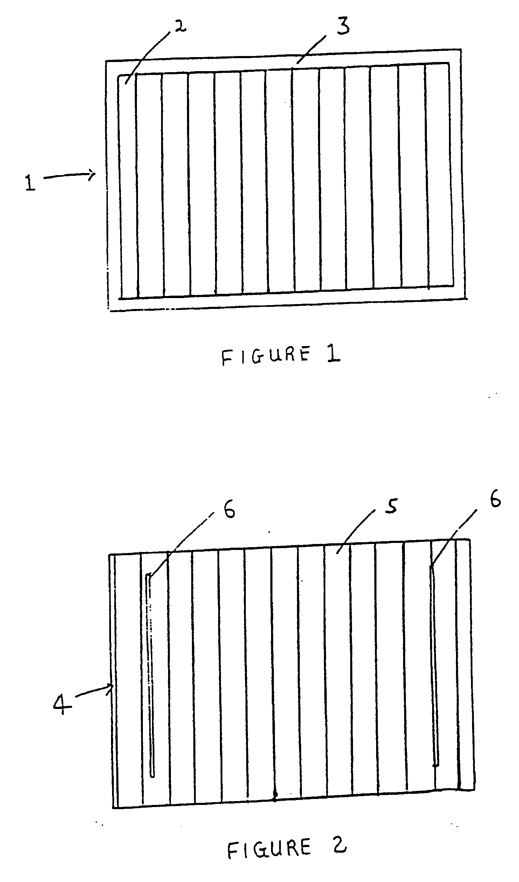

Referring to Figure 1 showing a pane, generally designated 1, with strips of tape 2 defining a 20 mm wide margin 3 around the periphery of the pane.

The exposed coated glass surface was degreased by washing with carbon tetrachloride and the pane mounted horizontally in a supporting frame with the coated surface upwards. A base layer of aluminium was then applied to the exposed coated surface by arc spraying, the spray gun being traversed over the perimeter of the glass surface. A TAFA 8830 electric arc spray gun (available from Mining and Chemical Products Limited of Stone, Staffordshire, England) was used with the following operating parameters :

Arc current 100 amps
Arc voltage 29 volts
Atomising air pressure 50 psi (3.4 bar × 10⁵ Pa)
Spray nozzle — work piece distance 450 mm
Speed of traverse 10 mm per second

The spray nozzle to work piece (coated glass) distance was selected to produce the required coating thickness and uniformity of coating with a single pass of the spray gun while avoiding overheating of the coating on the glass. A aluminium base layer having a thickness of 0.08 mm was deposited around the periphery of the glass pane.

A layer of zinc was then applied over the base layer of aluminium using the same spray gun with the following operating parameters :

Arc current 65 amps
Arc voltage 19 volts
Atomising air pressure 60 psi (4.08 bar × 10⁵ Pa)
Spray nozzle — work piece distance 150 mm
Speed of traverse 10 mm per second

Again, the spray nozzle to work piece distance was selected to produce the required coating thickness and uniformity of coating with a single pass of the spray gun while avoiding overheating of the coating on the glass. A zinc layer 0.06 mm thick was deposited over the layer of aluminium. The two layer coating constituted a bus bar around the periphery of coated glass, and had a resistance of less than 0.001 ohms per square and a total contact resistance of approximately 2 ohms. There was no apparent damage to the electroconductive coating on the glass and both the bus bar and the coated areas within the frame formed by the bus bar were uniform in appearance, and the electroconductive and optical properties of the coating not under the bus bar were unaffected.

A peripheral bus bar of this kind is useful when the coated glass is to be used as an electromagnetic shield, for which purpose the electroconductive coating should be earthed around its whole periphery.

## Example 2

Example 1 was repeated except that the masking tape was applied to both major surfaces of the glass leaving an exposed margin on each side of the glass and the glass turned over and sprayed around the margins on both sides and the edges, effectively "wrapping" the conductive bus bar around the edge faces of the glass and onto the back face. This permits electrical contact to the bus bar to be achieved, either from an edge face or the back face of the glass, even after the glass is laminated or formed into a sealed double glazing unit with the coated surface protected within the laminate or double glazing unit.

## Example 3

A rectangular pane of 4 mm coated glass similar to that used in Example 1 was cut to a size of 510 mm × 360 mm for use as a burglar alarm glass. The coated surface was then masked using low tack adhesive tape to define two parallel rectangular strips 3 mm wide and 300 mm long, with a perpendicular distance of 410 mm between the strips.

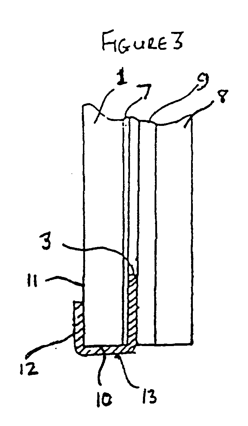

Referring now to Figure 2 showing a pane, generally designated 4, with strips of tape 5 defining parallel rectangular strips 6 for the bus bars.

The exposed coated glass surface was degreased by washing with carbon tetrachloride and the pane mounted horizontally on a supporting frame with the coated surface upwards. A base layer of aluminium was then applied to the exposed coated surface by arc spraying, the spray gun being traversed over the unmasked strips. The electric arc spray gun referred to in Example 1 was used with the same operating parameters used in Example 1 for application of the aluminium layer. An aluminium base layer having a thickness of 0.08 mm was deposited on the exposed strips of coated glass defined between the masking tape.

A layer of copper was then applied over the base layer of aluminium using the same spray gun with the following operating parameters :

Arc current 75 amps
Arc voltage 22 volts
Atomising air pressure 50 psi ($3.4 \times 10^5$ Pa)
Spray nozzle — work piece distance 450 mm
Speed of traverse 13.3 mm per second

The spray nozzle to work piece distance was selected to produce the required coating thickness and uniformity of coating with a single pass of the spray gun while avoiding overheating of the coating on the glass. A copper layer 0.05 mm thick was deposited over the layer of aluminium. The two layer sprayed metal coatings constituted bus bars for connection of an electrical potential across the coated glass whereby a change in the electrical conductivity of the glass on breakage of the glass could be detected with the production of a suitable alarm signal. Each bus bar had a resistance of less than 0.01 ohms per square and a contact resistance of 2 ohms.

There was no apparent damage to the electroconductive coating on the glass and both the bus bar and the coated area within the frame formed by the bus bar were uniform in appearance.

The parallel rectangular strips 6 serving as bus bars as shown in Figure 2 eminently suitable for serving as electrical connection means for electrically heated windscreens. Electrical connection to the bus bars being made in the usual manner by soldering or other suitable means.

The present invention enables durable bus bars to be applied to electroconductive coatings comprising a layer of metal oxide over a thin silver (e.g. 5 to 30 nm thick) layer without heating the coated glass or damaging the coating and is especially useful for applying bus bars to such coatings. Bus bars can be produced with high electrical conductivity and low contact resistance and, can as previously discussed readily be "wrapped around" the edge faces of the glass and may even extend to the face oposite the electroconductive coating in a continuous path to enable electrical contact to be made with the bars when the coated glass is laminated or used to produce a double glazing unit with its coated face inwards.

Referring to Figure 3, which illustrates, by way of example, a sectional side-view of a portion of a laminate including a glass pane 1 having an electroconductive coating 7 comprising a layer of silver with a protective metal oxide layer thereover, and a second glass pane 8 between which glass panes is sandwiched a plastics interlayer 9. The bus bar 3 is shown extending around the edge face 10 of the coated glass pane 1 and to the face opposite the coating to enable electrical contact to be made with the bus bar 3 at location 12 or 13 when the bus bar extends to the edge face only.

Although in Figure 1 the bus bar 3 is shown extending all around the perimeter of the glass pane 1, it is envisaged that in some circumstances the bus bars may be present on two opposing edges only or may even be present around the perimeter in the form of separate discontinuous strips.

## Claims

1. A method of applying a bus bar (3) to an electroconductive coating (7) on a glass substrate (1)

comprising a layer of metal oxide over an intermediate layer of silver, comprising the step of arc spraying molten metal in the required configuration onto the surface of the electroconductive coating (7) in a manner which enables the molten metal to penetrate the metal oxide layer and to come into low resistance electrical contact with the intermediate layer of silver without damaging the layer of silver, characterised in that the molten metal is sprayed to form a continuous path on the electroconductive coating (7) and to wrap around onto an edge face (10) of the glass substrate (1).

2. A method according to claim 1 wherein the molten metal used is aluminium.

3. A method according to claim 2 comprising overspraying the aluminium with a layer of copper, zinc, tin, a tin zinc alloy, stainless steel, nickel, brass or copper nickel alloy.

4. A method according to claims 1, 2 or 3, comprising arc spraying the molten metal such that the molten metal forms a continuous path which wraps around onto the face (11) of the glass substrate opposite the electroconductive coating (7).

5. A method according to any one of the preceeding claims, wherein a stencil of the required configuration is placed over the electroconductive coating (7) before arc spraying commences.

6. A method according to any one of claims 1 to 4 wherein strips of adhesive tape (5) are applied to the electroconductive coating in the required configuration before arc spraying commences.

7. A glass pane carrying an electroconductive coating (7), comprising a layer of metal oxide over a layer of silver and at least one bus bar (3) of arc sprayed metal over said electroconductive layer (7), the arc sprayed metal having penetrated the metal oxide layer so as to be in low resistance electrical contact with the layer of silver without causing damage to the layer of silver, characterised in that the arc sprayed metal on the electroconductive coating extends in a continuous path onto an edge face (10) of the glass pane (1).

8. A glass pane according to claim 8 wherein the arc sprayed metal is aluminium.

9. A glass pane according to claim 8, comprising at least one aluminium bus bar over which is a layer of copper, zinc, tin, a tin alloy, stainless steel, nickel, brass or copper nickel alloy.

10. A glass pane according to claims 7, 8 or 9, comprising arc sprayed aluminium on the electroconductive coating (7) which extends in a continuous path onto the face (11) of the glass pane opposite the electroconductive coating (7).

**Revendications**

1. Procédé d'application d'une barre collectrice (3) à un revêtement électroconducteur (7) sur un substrat de verre (1) comprenant une couche d'oxyde métallique par dessus une couche intermédiaire comprenant l'étape de pulvérisation à l'arc de métal fondu dans la configuration requise sur la surface du revêtement électroconducteur (7) d'une façon qui permette au métal fondu de pénétrer la couche d'oxyde métallique et de venir en contact électrique de faible résistance avec la couche intermédiaire d'argent sans endommager la couche d'argent, caractérisé en ce que le métal fondu est pulvérisé pour former un trajet continu sur le revêtement électroconducteur (7) et pour s'enrouler autour d'un chant (10) du substrat de verre (1).

2. Procédé selon la revendication 1, dans lequel le métal fondu utilisé est de l'aluminium.

3. Procédé selon la revendication 2, comprenant une pulvérisation par dessus l'aluminium d'une couche de cuivre de zinc, d'étain, d'un alliage d'étain et de zinc, d'acier inoxydable, de nickel, de laiton ou d'un alliage de nickel et de cuivre.

4. Procédé selon la revendication 1, 2 ou 3, comprenant la pulvérisation à l'arc du métal fondu de manière à ce que le métal forme un trajet continu qui s'enroule autour de la face (11) du substrat de verre opposée au revêtement électroconducteur (7).

5. Procédé selon l'une quelconque des revendications précédentes dans lequel un pochoir de la configuration requise est placé sur le revêtement électroconducteur (7) avant de commencer la pulvérisation à l'arc.

6. Procédé selon l'une quelconque des revendications 1 à 4, dans lequel des lignes de bande adhésive (5) sont appliquées au revêtement électroconducteur dans la configuration requise avant de commencer la pulvérisation à l'arc.

7. Panneau de verre supportant un revêtement électroconducteur (7) comprenant une couche d'oxyde métallique par dessus une couche d'argent et au moins une barre collectrice (3) de métal pulvérisé à l'arc par dessus ladite couche électroconductrice (7), le métal pulvérisé à l'arc ayant pénétré la couche d'oxyde métallique de manière à être en contact électrique de faible résistance avec la couche d'argent sans provoquer de dommage à la couche d'argent, caractérisé en ce que le métal pulvérisé à l'arc sur la couche électroconductrice s'étend selon un trajet continu sur une face de chant (10) du panneau de verre (1).

8. Panneau de verre selon la revendication (8), dans lequel le métal pulvérisé à l'arc est de l'aluminium.

9. Panneau de verre selon la revendication 8, comprenant au moins une barre collectrice d'aluminium par dessus laquelle se trouve une couche de cuivre de zinc, d'étain, d'un alliage d'étain de cuivre de zinc, d'étain, d'un alliage d'étain, d'acier inoxydable, de nickel, de laiton ou d'un alliage de nickel et de cuivre.

10. Panneau de verre selon la revendication 7, 8, ou 9 comprenant de l'aluminium pulvérisé à l'arc sur le revêtement électroconducteur (7) qui s'étend en un trajet continu sur la face (11) du panneau de verre opposée au revêtement électroconducteur (7).

**Patentansprüche**

1. Verfahren zum Anbringen einer Sammelschiene (3) an einer elektrisch leitenden Beschichtung (7) auf einer Glasunterlage (1), die eine Metalloxidschicht über einer Silberzwischenschicht aufweist, wobei im Sprühlichtbogen geschmolzenes Metall in der erforderlichen Form auf die Oberfläche der elektrisch leitenden Beschichtung (7) derart aufgesprüht wird, daß das geschmolzene Metall die Metalloxidschicht durchdringen und in elektrischen Kontakt niedrigen Widerstands mit der Silberzwischenschicht ohne Beschädigung der Silberschicht kommen kann, dadurch gekennzeichnet, daß das geschmolzene Metall derart aufgesprüht wird, daß es eine zusammenhängende Bahn auf der elektrisch leitenden Beschichtung bildet und sich umhüllend auf eine Stirnfläche (10) der Glasunterlagen (1) erstreckt.

2. Verfahren nach Anspruch 1, worin als geschmolzenes Metall Aluminium verwendet wird.

3. Verfahren nach Anspruch 2, bei dem das Aluminium mit einer Schicht aus Kupfer, Zink, Zinn, einer Zinn-Zink-Legierung, rostfreiem Stahl, Nickel, Messing oder Kupfer-Nickel-Legierung übersprüht wird.

4. Verfahren nach den Ansprüchen 1, 2 oder 3, bei dem im Sprühlichtbogen das geschmolzene Metall derart aufgesprüht wird, daß es eine zusammenhängende Bahn bildet, die sich umhüllend auf die Fläche (11) der Glasunterlage erstreckt, welche der elektrisch leitenden Beschichtung (7) entgegengesetzt ist.

5. Verfahren nach einem der vorangehenden Ansprüche, bei dem eine Schablone in der erforderlichen Form über die elektrisch leitende Beschichtung (7) gelegt wird, bevor das Lichtbogensprühen beginnt.

6. Verfahren nach einem der Ansprüche 1 bis 4, bei dem Klebbandstreifen (5) auf die elektrisch leitende Beschichtung in der erforderlichen Form aufgebracht werden, bevor das Lichtbogensprühen beginnt.

7. Glasplatte, welche eine elektrisch leitende Beschichtung (7) trägt, mit einer Metalloxidschicht über einer Silberschicht und mindestens einer Sammelschiene (3) aus im Lichtbogen aufgesprühtem Metall über der elektrisch leitenden Schicht (7), wobei das im Lichtbogen aufgesprühte Metall die Metalloxidschicht derart durchdrungen hat, daß sie in elektrischem Kontakt niedrigen Widerstands mit der Silberschicht steht, ohne die Silberschicht beschädigt zu haben, dadurch gekennzeichnet, daß das im Lichtbogen auf die elektrisch leitende Schicht aufgesprühte Metall sich in einer zusammenhängenden Bahn auf eine Stirnfläche (10) der Glasplatte (1) erstreckt.

8. Glasplatte nach Anspruch 8, bei der das im Lichtbogen aufgesprühte Metall Aluminium ist.

9. Glasplatte nach Anspruch 8 mit mindestens einer Aluminium-Sammelschiene, über der sich eine Schicht aus Kupfer, Zink, Zinn, Zinnlegierung, rostfreiem Stahl, Nickel, Messing oder Kupfer-Nickel-Legierung befindet.

10. Glasplatte nach Anspruch 7, 8 oder 9, mit im Lichtbogen aufgesprühtem Aluminium auf der elektrisch leitenden Schicht (7), das sich in einer zusammenhängenden Bahn auf die Fläche (11) der Glasplatte erstreckt, die der elektrisch leitenden Schicht (7) entgegengesetzt ist.

FIGURE 1

FIGURE 2

FiGuRE 3